# EUROPEAN PATENT SPECIFICATION

(11) **EP 3 929 968 B1**
(45) Date of publication and mention of the grant of the patent: **11.01.2023**
(21) Application number: 21179639.6
(22) Date of filing: 15.06.2021
(51) Int. Cl.: H01L 21/67

(54) **WET PROCESS MODULE AND METHOD OF OPERATION**
NASSVERFAHRENSMODUL UND VERFAHREN ZUM BETRIEB
MODULE DE TRAITEMENT PAR VOIE HUMIDE ET SON PROCÉDÉ DE FONCTIONNEMENT

(30) Priority: 25.06.2020 NL 2025916
(43) Date of publication of application: 29.12.2021
(73) Proprietor: Suss MicroTec Lithography GmbH, 85748 Garching (DE)
(72) Inventor: BRAUN, Michael, 85748 Garching (DE); SCHUTZBACH, Simon, 85748 Garching (DE)
(74) Representative: Prinz & Partner mbB

(56) References cited:
- US-A1- 2005 074 983
- US-A1- 2006 124 060
- US-A1- 2009 302 024
- US-A1- 2016 189 988
- US-B1- 6 332 724

## Description

The invention relates to a wet process module, in particular to a lacquering module for the treatment of substrates, and to a method of operating such a wet process module.

Wet process modules are known and include a process chamber having a process pot in which the substrate is treated with a liquid, usually a lacquer. During operation, conditioned air flows through the process chamber, which flows into the process chamber at a specific temperature and humidity via a supply unit and is discharged via an extraction line. Depending on the application, different volume flows of air flowing through the process chamber are required during the treatment process.

This often leads to fluctuations in the volume flow at other modules of the system, since all modules are usually connected to a common air supply and/or a common extraction line. In addition, fluctuations of the air supply and the air discharge, in particular due to inadequate or missing regulation, will affect the process conditions.

The following documents are cited as representative prior art examples:
US 6332724 B1
US 2006/124060 A1
US 2016/189988 A1
US 2009/302024 A1
US 2005/0744983 A1

The object of the invention is to provide a wet process module which ensures an improved process environment and thus products of higher quality or less waste. The object of the invention is also to provide a method of operating such a wet process module.

To achieve the object, a wet process module, in particular a lacquering module, is provided for the treatment of substrates, in particular wafers. The wet process module includes a process chamber which has a process pot for treating the substrate, an air inlet for supplying air into the process chamber, at least one bypass outlet and at least one process pot outlet. The at least one bypass outlet and the at least one process pot outlet are air outlets for discharging air from the process chamber. Furthermore, the at least one process pot outlet is provided in the area of the process pot, and the at least one bypass outlet is provided outside the process pot. In this way, the air in the process chamber can flow out of the process chamber both through the at least one process pot outlet, and thus through the process pot, and also through the at least one bypass outlet, and thus past the process pot, i.e. not through the process pot. The bypass outlet thus forms a bypass via which an air flow can be directed past the process pot. Due to this design, the volume flow of air flowing out of the process chamber via the process pot through the at least one process pot outlet can be adjusted by the volume flow flowing out of the process chamber via the bypass. The wet process module can thus always extract the same volume flow of air, thus preventing fluctuations to other wet process modules.

In particular, the flow connection between the air inlet and the at least one bypass outlet always runs outside the process pot.

For example, air is supplied via the air inlet into the process chamber by a supply unit.

The wet process module may have a diffuser coupled to the air inlet via which the air flows into the interior of the process chamber in a distributed manner. In this way, a uniform, in particular laminar volume flow of air into the process chamber can be generated.

Alternatively or additionally, a filter coupled to the air inlet may be provided, through which the air flowing into the process chamber is cleaned. In this way, contamination of the process chamber by particles can be reduced or prevented.

For example, the filter is located in front of the diffuser in the direction of flow.

It may also be provided that the filter is integrated in the diffuser or vice versa. In other words, the filter may have an air distribution function, or the diffuser may have a filtering function.

In one embodiment, the air inlet on the one hand and the air outlets on the other hand are provided on different, particularly opposite sides of the process chamber. Additionally or alternatively, the at least one process pot outlet and the at least one bypass outlet may be provided on the same side of the process chamber. A particularly favorable flow pattern in the process chamber is thus ensured.

The air inlet may be provided on a roof of the process chamber and/or the at least one process pot outlet and the at least one bypass outlet may be provided on a bottom of the process chamber.

It may also be provided that the at least one bypass outlet extends at least in sections in an annular shape around the process pot and/or that a plurality of bypass outlets arranged around the process pot is provided. This has the advantage that at several points around the process pot, air can flow out of the process chamber via the bypass, thus forming a flow pattern in the process chamber which ensures a particularly good process environment.

In a further embodiment, the wet process module includes an exhaust air device having at least one process pot channel and at least one bypass channel. Here, the at least one process pot channel extends from the at least one process pot outlet and the at least one bypass channel from the at least one bypass outlet. In this way, the air flowing out of the process chamber via the at least one process pot outlet can be directed through the at least one process pot channel, while the air flowing out of the process chamber via the at least one bypass outlet can be directed through the at least one bypass channel.

It is advantageous here if a regulating means, in particular a throttle valve is provided in the at least one bypass channel, by means of which the cross-section of the bypass channel through which a flow can pass can be regulated. The volume flow which flows out of the process chamber via the bypass and thus indirectly the volume flow which flows out of the process chamber via the process pot can therefore be regulated.

In embodiments having several bypass channels, these can open into a common channel section.

In this case, the regulating means is preferably arranged in this common channel section in order to be able to control via closed-loop and/or open-loop the volume flow through all bypass outlets together using a regulating means.

According to one embodiment, the at least one process pot channel is fluidically connected to the at least one bypass channel so that the air volume flowing through the at least one process pot channel and the air volume flowing through the at least one bypass channel can be discharged together via an extraction line. Furthermore, the exhaust air device can thus have a common exhaust air port for the at least one process pot channel and the at least one bypass channel via which the exhaust air device can be connected to an extraction line.

In particular, the at least one process pot channel is fluidically connected to the at least one bypass channel downstream of the regulating means of the bypass channel, so that the regulating means cannot be contaminated by substances such as lacquer which are introduced into the at least one process pot channel, and thus the function thereof cannot be impaired.

To prevent contamination of the at least one process pot channel and/or of downstream channels, the at least one process pot channel may have a lacquer trap. The lacquer trap is designed to separate and collect solid and liquid substances by means of gravity.

In embodiments having several process pot channels, these can open into a common channel section.

In this case, the lacquer trap is preferably arranged in this common channel section in order to be able to separate the substances which are introduced via all process pot outlets by means of a lacquer trap.

In addition or alternatively, it is advantageous if the at least one process pot channel has no regulating means, such as a throttle valve, which can be contaminated by substances introduced into the at least one process pot channel, such as lacquer, and the function of which can thus be impaired.

In particular, the at least one process pot channel has no regulating means at all.

According to a further embodiment, the wet process module has a pressure sensor configured to detect the air pressure in the process chamber. The air pressure in the process chamber is an important parameter which determines the volume flows via the supply unit into the process chamber and/or through the at least one process pot outlet and the at least one bypass outlet, and thus has a decisive influence on the quality of the process environment.

The pressure sensor may in particular be located within the process chamber and/or adjacent to the air volume within the process chamber.

For example, the pressure sensor is arranged outside the process chamber and is fluidically coupled to the air volume within the process chamber via a pipe.

It may furthermore be provided that the wet process module has a control unit which is connected in a signal-transmitting manner to the regulating means and/or to a supply unit of the wet process module and is set up to control via closed-loop or open-loop the regulating means and/or the supply unit, in particular depending on the air pressure in the process chamber and/or the current process step. In this way, a particularly high-quality process environment can be reliably and effectively ensured, resulting in products of particularly high quality.

In particular, the control unit is set up to carry out the following process.

According to the invention, a method of operating a wet process module according to the invention is also provided for achieving the above mentioned object, comprising the following steps:
a) feeding a known, in particular a constant, volume flow of air through the air inlet into the process chamber, and
b) controlling or regulating the volume flow of air exiting the process chamber through the at least one bypass outlet

In this way, the volume flow flowing out of the process chamber via the process pot is indirectly controlled via closed-loop or open-loop by the volume flow flowing out of the process chamber via the bypass. However, the total amount of air flowing out of the process chamber remains essentially constant. Therefore, a particularly favorable process environment with advantageous flow patterns, in particular in the process pot, can be reliably provided, in particular over the entire treatment process of a substrate.

The volume flow of air exiting the process chamber through the at least one bypass outlet can be controlled via closed-loop or open-loop by a regulating means in the at least one bypass channel. It is thus possible to adjust the volume flow particularly quickly and accurately.

The advantages and features discussed for the wet process module apply equally to the process and vice versa.

The components that perform steps of the process are of course also set up to perform the steps.

The regulating means and/or the supply means is in particular controlled by the control unit.

In one embodiment, the cross-section of the at least one process pot channel through which a flow pass is not actively changed, i.e. in particular not actively controlled via closed-loop or open-loop. Thus, the cross-section of the at least one process pot channel remains constant, apart from secondary effects such as contamination which accumulates in the at least one process pot channel during operation.

It may also be provided that the air pressure in the process chamber is regulated such that there is a slight overpressure in the process chamber compared to the ambient pressure at the installation site of the wet process module. The advantage of an overpressure compared to a negative pressure in the process chamber is that in this way no particles are sucked into the process area if the process chamber is not completely sealed from the environment. This effectively reduces the amount of particles which can negatively influence the process result.

For example, the volume flow of air into the process chamber is regulated by regulating the supply unit via the control unit, in particular on the basis of the data acquired by the pressure sensor, in order to generate an essentially constant air pressure, in particular overpressure in the process chamber.

Within the meaning of the invention, a slight overpressure is a pressure which is between 100.1% and 110% of the ambient pressure.

According to a further embodiment, a known, in particular constant volume flow of air is extracted from the process chamber via the exhaust air device. In particular, the volume flow extracted by the exhaust air device is smaller than the volume flow of air supplied to the process chamber. In this way, an overpressure in the process chamber can be reliably ensured.

Further advantages and features will become apparent from the description below and from the accompanying drawings, in which:
- Figure 1 shows a schematic side view of a wet process module according to the invention having a process chamber in,
- Figure 2 shows a schematic plan view of the process chamber of the wet process module according to the invention in a first variant, and
- Figure 3 shows a schematic plan view of the process chamber of the wet process module according to the invention in a second variant.

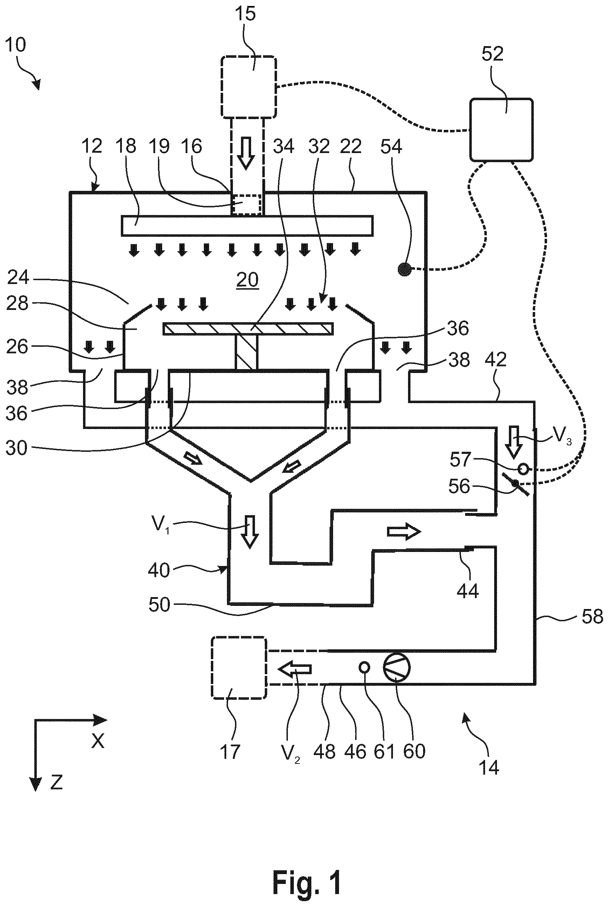

Figure 1 shows a wet process module 10 including a process chamber 12 and an exhaust air device 14.

In the present example embodiment, the wet process module 10 is a lacquering module provided for coating a substrate with a lacquering.

In principle, the wet process module 10 may be provided in an alternative embodiment for any wet process for the treatment of a substrate.

The process chamber 12 has an air inlet 16, a filter 19, a diffuser 18, a process pot 24, a plurality of process pot outlets 36 and a plurality of bypass outlets 38.

In this embodiment, the filter 19 is fluidically connected upstream of the diffusor 18 and serves to remove particles from the air flowing into the process chamber 12.

By means of the diffuser 18, air can be guided into the interior 20 of the process chamber 12 in a distributed manner. In particular, a laminar airflow into the process chamber 12 can thus be created.

In an alternative embodiment, the process chamber 12 may of course have any number of air inlets 16 with or without filter 19 and/or diffuser 18.

It is also possible that the filter 19 is integrated into the diffuser 18 or vice versa.

In the figures, air flows are represented by arrows.

The air is preferably provided by a supply unit 15 having an air conditioning means, which feeds air into the process chamber 12 at a defined temperature and humidity.

The air inlet 16 is provided in a roof 22 of the process chamber 12.

In principle, however, the air inlet 16 may lead into the interior 20 of the process chamber 12 at any point.

The process pot 24 has a process pot wall 26 which delimits a process area 28 in the interior 20 of the process chamber 12.

In the present example embodiment, the process pot 24 is provided on a bottom 30 of the process chamber 12, the process pot wall 26 extending from the bottom 30 towards the roof 22.

The process pot wall 26 is preferably completely closed in the circumferential direction, so that air in the interior 20 of the process chamber 12 can only flow into the process area 28 via a process pot opening 32 of the process pot 24.

In the process area 28, the process chamber 12 has a chuck 34 for the treatment of a substrate (not shown).

The diffuser 18 is arranged opposite the chuck 34, so that the air flowing into the process chamber 12 via the air inlet 16 flows in a vertical direction Z over the process pot opening 32 and onto the substrate, which is arranged on the chuck 34.

To guide air out of the interior 20 of the process chamber 12, provision is made for the process pot outlets 36, which are arranged in the process pot 24 and adjoin the process area 28, and the bypass outlets 38, which are arranged outside the process pot 24 and do not adjoin the process area 28.

The process pot outlets 36 and the bypass outlets 38 are provided in the bottom 30 of the process chamber 12.

In an alternative embodiment, the process pot outlets 36 and/or the bypass outlets 38 may lead out of the process chamber 12 at any point.

Preferably, the process pot outlets 36 and the bypass outlets 38 are arranged on a common side of the process chamber 12, which is particularly opposite the side of the process chamber 12 where the air inlet 16 is located.

In principle, the process chamber 12 may have any number of process pot outlets 36 and bypass outlets 38.

Apart from the air inlet 16 and the process pot outlets 36 and the bypass outlets 38, the process chamber 12 is closed but may have leaks.

The process pot outlets 36 are preferably arranged in an annular shape around the chuck 34 and/or extend at least in sections in an annular shape around the chuck 34, in particular if the process chamber 12 has only one process pot outlet 36.

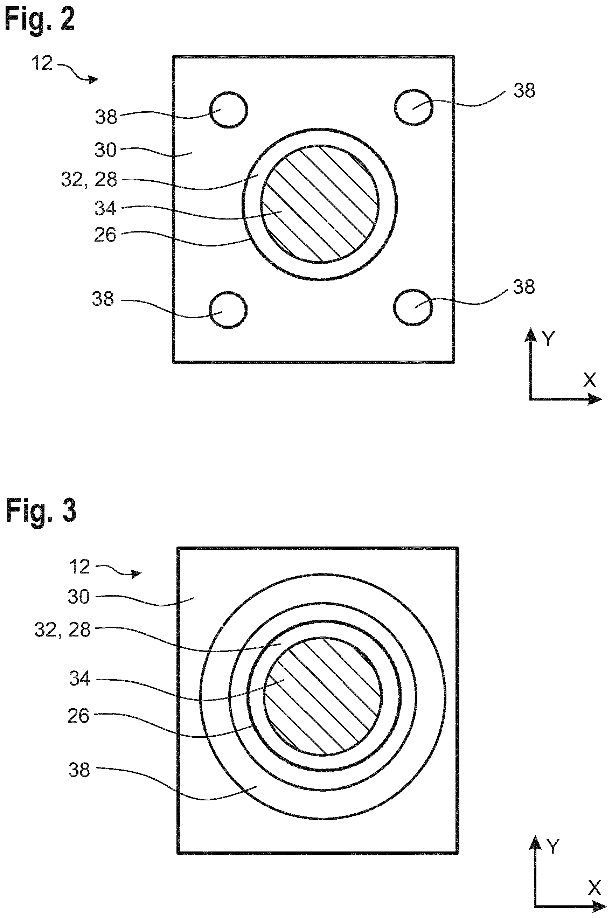

In the present example embodiment, the process chamber 12 has four bypass outlets 38 (see figure 2), which are arranged in an annular shape and symmetrically around the process pot 24.

Of course, a different number of bypass outlets 38 may also be provided, for example two.

In an alternative embodiment, as shown in Figure 3, the process chamber 12 has a single bypass outlet 38 which extends circularly and concentrically around the process pot 24.

In an alternative embodiment, the bypass outlets 38 can of course be arranged arbitrarily around the process pot 24.

It is also possible to arrange a plurality of bypass outlets at one side of the process pot 24.

The exhaust air device 14 is fluidically connected to the interior 20 of the process chamber 12 via the process pot outlets 36 and the bypass outlets 38, and to this end, it has a process pot channel 40, which is connected to the process pot outlets 36, and a bypass channel 42, which is connected to the bypass outlets 38.

The downstream end 44 of the process pot channel 40 opens into the bypass channel 42, the downstream end 46 of which in turn forms an exhaust air outlet 48 of the exhaust air device 14, where the air flowing into the process chamber 12 through the air inlet 16 is guided out of the wet process module 10 via the exhaust air device 14.

In an alternative embodiment, the downstream end 46 of the bypass channel 42 may open into the process pot channel 40, in particular wherein the downstream end 44 of the process pot channel 40 forms the exhaust air outlet 48.

Before the two channels 40, 42 open into each other, a regulating means 56, for example a throttle valve, is arranged in the bypass channel 42, in particular in a common section of several or all bypass channels 42.

The regulating means 56 is thus arranged in the bypass channel 42 upstream of the point where the process pot channel 40 opens into the bypass channel 42.

The regulating means 56 is configured to change the opening cross-section of the bypass channel 42.

The wet process module 10 further has a first volume flow sensor 57, which is set up to determine the volume flow of air flowing from the interior 20 of the process chamber 12 via the bypass outlets 38 into the bypass channel 42 and consequently through the bypass channel 42.

For this purpose, the first volume flow sensor 57 is located upstream of the point where the process pot channel 40 opens into the bypass channel 42, for example in the area of the regulating means 56.

In principle, the process pot channel 40 and the bypass channel 42 can be designed separately from each other and do not open into each other, in particular wherein the downstream end 44, 46 of the process pot channel 40 and of the bypass channel 42 each form a separate exhaust air outlet 48. The regulating means 56 is then also provided in the bypass channel 42.

In a further alternative embodiment, the process pot channel 40 and the bypass channel 42 can of course also lead into a further channel of the exhaust air device 14, the end of which forms the exhaust air outlet 48.

The process pot channel 40 also has a lacquer trap 50, which is provided for collecting and separating dirt particles and lacquer, which are introduced into the process pot channel 40 via the process pot outlets 36.

The lacquer trap 50 is designed in the form of a siphon, for example.

The wet process module 10 further comprises a control unit 52 and a pressure sensor 54.

The regulating means 56, the first volume flow sensor 57, the supply unit 15 and the pressure sensor 54 are each connected to the control unit 52 in a signal transmitting manner.

The pressure sensor 54 in the embodiment shown is located in the interior 20 of the process chamber 12 and is designed to determine the air pressure in the interior 20 of the process chamber 12.

In principle, the pressure sensor 54 may be provided at any position where it can determine the air pressure in the interior 20 of the process chamber 12.

For example, the pressure sensor 54 can be located outside the process chamber 12 and can be fluidically coupled to the air volume inside the process chamber 12 via a pipe.

To ensure a particularly favorable process environment in the process area 28, the wet process module 10 is operated as described below.

During operation, a conditioned air flow is fed into the interior 20 of the process chamber 12 via the air inlet 16 by means of the supply unit 15.

The volume flow fed into the process chamber 12 is known and predominantly constant.

Alternatively, the volume flow flowing into the process chamber 12 can be controlled by the control unit 52, in particular depending on the air pressure in the process chamber 52 detected by the pressure sensor 54 and/or on individual process steps.

In states in which the regulating means 56 is at least partially open, part of the air flows from the interior 20 of the process chamber 12 via the bypass outlets 38 into the bypass channel 42.

Furthermore, in all states of the regulating means 56, at least part of the air from the interior 20 of the process chamber 12 flows through the process area 28 and via the process pot outlets 36 into the process pot channel 40.

The air flow through the process pot outlets 36 is in particular a central parameter in the regulation of the air flow in the process chamber 12.

The air in the process pot channel 40 and the air in the bypass channel 42 flow to the exhaust air outlet 48, in the present example embodiment via the downstream section 58.

In the downstream section 58, a fan 60, which generates an air flow, and a second volume flow sensor 61 are provided, which is set up to determine the volume flow of air flowing through the downstream section 58.

The fan 60 and the second volume flow sensor 61 can each be coupled for signal transmission to the control unit 52 or to a separate control unit.

The air can be extracted at the exhaust air outlet 48 by means of an extraction means 17 such as an extraction line.

In one embodiment, a smaller volume flow of air is extracted at the exhaust air outlet 48 than the volume flow which is fed into the process chamber 12 via the air inlet 16 by the supply unit 15. This creates an overpressure in the interior 20 of the process chamber 12, so that air flows out of the interior 20 via leaks in the process chamber 12 and is not sucked in from the environment, as would be the case with a negative pressure in the interior 20 of the process chamber 12.

The volume flow of air, which is fed into the process chamber 12 via the supply unit 15, can be adjusted depending on the air pressure in the interior 20 of the process chamber 12. The air pressure is determined by the pressure sensor 54. In this way, a defined, in particular constant, air pressure, in particular overpressure, is provided in the interior 20 of the process chamber 12.

Alternatively or additionally, the volume flow of air which flows out of the process chamber 12 via the exhaust air outlet 48 or is extracted via this outlet can be adjusted on the basis of the air pressure in the interior 20 of the process chamber 12, which is determined by the pressure sensor 54, to provide a defined, in particular constant, air pressure, in particular overpressure in the interior 20 of the process chamber 12.

Furthermore, the proportion of air which flows out of the interior 20 of the process chamber 12 via the bypass and thus does not flow through the process area 28 may be adjusted by means of the regulating means 56.

At the same time, the proportion of air flowing out of the interior 20 of the process chamber 12 through the process area 28 is also indirectly adjusted.

The volume flow V₁, which flows out of the interior 20 of the process chamber 12 through the process area 28 and via the process pot outlets 36 through the process pot channel 40, corresponds to the volume flow V₂, which flows out via the exhaust air outlets 48 and is determined by the second volume flow sensor 61, minus the volume flow V₃, which flows out of the interior 20 of the process chamber 12 via the bypass outlets 38 through the bypass channel 42 and is determined by the first volume flow sensor 57. Expressed as a mathematical formula: V₁ = V₂ - V₃.

During operation of the wet process module 10, the control unit 52 can thus be used to control or regulate the volume flow flowing through the process area 28 via the regulating means 56 in conjunction with the fan 60 - which thus also constitutes a regulating means - in the bypass channel 42.

The total amount of air flowing out of the exhaust air outlet 48 remains constant.

In particular, the regulating means 56 is controlled or regulated depending on the current process step by means of the control unit 52 to provide volume flows adapted to the appropriate process step.

Additionally or alternatively, the air pressure in the interior 20 of the process chamber 12 can be taken into account when regulating or controlling the regulating means 56.

In this way, a favorable process environment is provided particularly reliably in the process area 28, as the regulating means 56, which regulates or controls the air flow through the process area 28, is located in the bypass channel 42 and thus cannot be contaminated by lacquer, which is introduced into the exhaust air device 14 via the process pot outlets 36.

In the same way, the first volume flow sensor 57 is protected against contamination by lacquer.

A further advantage of the wet process module 10 is that by means of the fan 60 a varying extraction and/or a too weak or too strong extraction of the extraction unit 17 can be compensated for, so that there is always a substantially constant air pressure, in particular overpressure in the interior 20 of the process chamber 12.

For this purpose, the fan 60 is controlled or regulated via the control unit assigned thereto or the control unit 52, in particular on the basis of the data determined by the second volume flow sensor 61. The fan 60 can be controlled or regulated in conjunction with the control or regulation of the control unit 56.

The volume flow of air through the process area 28 can be regulated via the regulating means 56, so that optimum process conditions are constantly maintained.

Furthermore, the air supply and the extraction of the wet process module 10 can be regulated separately.

The invention is defined by the appended set of claims.

## Claims

1. A wet process module, in particular a lacquering module, for the treatment of substrates, in particular wafers, including a process chamber (12) which has a process pot (24) for treating the substrate, an air inlet (16) for supplying air into the process chamber (12), at least one bypass outlet (38) and at least one process pot outlet (36),
wherein the at least one bypass outlet (38) and the at least one process pot outlet (36) are air outlets for discharging air out of the process chamber (12), and
wherein the at least one process pot outlet (36) is provided in the process pot (24) and the at least one bypass outlet (38) is provided outside the process pot (24).

2. The wet process module according to claim 1, **characterized in that** the air inlet (16) on the one hand and the air outlets (36, 38) on the other hand are provided on different, in particular opposite sides of the process chamber (12), and/or **in that** the at least one process pot outlet (36) and the at least one bypass outlet (38) are provided on the same side of the process chamber (12).

3. The wet process module according to claim 1 or 2, **characterized in that** the at least one bypass outlet (38) extends at least in sections in an annular shape around the process pot (24) and/or **in that** a plurality of bypass outlets (38) arranged around the process pot (24) is provided.

4. The wet process module according to any of the preceding claims, **characterized in that** the wet process module (10) has a pressure sensor (54) which is configured so as to determine the air pressure in the process chamber (12).

5. The wet process module according to any of the preceding claims, **characterized in that** the wet process module (10) comprises an exhaust air device (14) having at least one process pot channel (40) and at least one bypass channel (42), wherein the at least one process pot channel (40) extends from the at least one process pot outlet (36) and the at least one bypass channel (42) extends from the at least one bypass outlet (38).

6. The wet process module according to claim 5, **characterized in that** a regulating means (56), in particular a throttle valve, is provided in the at least one bypass channel (42), by means of which the cross-section of the bypass channel (42) through which a flow can pass can be regulated.

7. The wet process module according to claim 6, **characterized in that** the wet process module (10) has a control unit (52) which is connected to the regulating means (56) and/or a supply unit (15) of the wet process module and is arranged to control or regulate the regulating means (56) and/or the supply unit (15), in particular depending on the air pressure in the process chamber (12) and/or the current process step.

8. The wet process module according to any of claims 5 to 7, **characterized in that** the at least one process pot channel (40) is fluidically connected to the at least one bypass channel (42), in particular downstream of the regulating means (56) of the bypass channel (42).

9. The wet process module according to any of claims 5 to 8, **characterized in that** the at least one process pot channel (40) has a lacquer trap (50) and/or no regulating means (56).

10. A method of operating a wet process module (10) according to any of the preceding claims, comprising the following steps:
a) feeding a known, in particular a constant, volume flow of air through the air inlet (16) into the process chamber (12), and
b) controlling via closed-loop or open-loop the volume flow of air exiting the process chamber (12) through the at least one bypass outlet (38).

11. The method according to claim 10, **characterized in that** the volume flow of air exiting the process chamber (12) through the at least one bypass outlet (38) is controlled via closed-loop or open-loop by a regulating means (56) in the at least one bypass channel (42).

12. The method according to claim 10 or 11, **characterized in that** the cross-section of the at least one process pot channel (40) through which a flow passes is not actively changed.

13. The method according to any of claims 10 to 12, **characterized in that** the air pressure in the process chamber (12) is regulated such that an overpressure prevails in the process chamber (12).

14. The method according to any of claims 10 to 13, **characterized in that** a known, in particular constant volume flow of air is extracted from the process chamber (12) via the exhaust air device (14), in particular wherein the volume flow extracted by the exhaust air device (14) is smaller than the volume flow of air supplied to the process chamber (12).

## Patentansprüche

1. Nassprozessmodul, insbesondere Belackungsmodul, zur Behandlung von Substraten, insbesondere Wafern, mit einer Prozesskammer (12), die einen Prozesstopf (24) zur Behandlung des Substrats, einen Lufteinlass (16) zur Zufuhr von Luft in die Prozesskammer (12) hinein, wenigstens einen Bypassauslass (38) und wenigstens einen Prozesstopfauslass (36) aufweist,
wobei der wenigstens eine Bypassauslass (38) und der wenigstens eine Prozesstopfauslass (36) Luftauslässe zur Abfuhr von Luft aus der Prozesskammer (12) hinaus sind, und
wobei der wenigstens eine Prozesstopfauslass (36) im Prozesstopf (24) vorgesehen ist und der wenigstens eine Bypassauslass (38) außerhalb des Prozesstopfes (24) vorgesehen ist.

2. Nassprozessmodul nach Anspruch 1, **dadurch gekennzeichnet, dass** der Lufteinlass (16) einerseits und die Luftauslässe (36, 38) andererseits an verschiedenen, insbesondere gegenüberliegenden Seiten der Prozesskammer (12) vorgesehen sind, und/oder dass der wenigstens eine Prozesstopfauslass (36) und der wenigstens eine Bypassauslass (38) an der gleichen Seite der Prozesskammer (12) vorgesehen sind.

3. Nassprozessmodul nach Anspruch 1 oder 2, **dadurch gekennzeichnet, dass** sich der wenigstens eine Bypassauslass (38) zumindest abschnittsweise ringförmig um den Prozesstopf (24) erstreckt und/oder dass mehrere Bypassauslässe (38) vorgesehen sind, die um den Prozesstopf (24) herum angeordnet sind.

4. Nassprozessmodul nach einem der vorhergehenden Ansprüche, **dadurch gekennzeichnet, dass** das Nassprozessmodul (10) einen Drucksensor (54) aufweist, der dazu ausgebildet ist, den Luftdruck in der Prozesskammer (12) zu ermitteln.

5. Nassprozessmodul nach einem der vorhergehenden Ansprüche, **dadurch gekennzeichnet, dass** das Nassprozessmodul (10) eine Abluftvorrichtung (14) mit wenigstens einem Prozesstopfkanal (40) und wenigstens einem Bypasskanal (42) aufweist, wobei sich der wenigstens eine Prozesstopfkanal (40) vom wenigstens einen Prozesstopfauslass (36) ausgehend und der wenigstens eine Bypasskanal (42) vom wenigstens einen Bypassauslass (38) ausgehend erstreckt.

6. Nassprozessmodul nach Anspruch 5, **dadurch gekennzeichnet, dass** im wenigstens einen Bypasskanal (42) eine Regeleinrichtung (56) vorgesehen ist, insbesondere eine Drosselklappe, mittels der der durchströmbare Querschnitt des Bypasskanals (42) regelbar ist.

7. Nassprozessmodul nach Anspruch 6, **dadurch gekennzeichnet, dass** das Nassprozessmodul (10) eine Steuereinheit (52) aufweist, die mit der Regeleinrichtung (56) und/oder einer Versorgungseinheit (15) des Nassprozessmoduls verbunden und dazu eingerichtet ist, die Regeleinrichtung (56) und/oder die Versorgungseinheit (15) zu steuern oder zu regeln, insbesondere in Abhängigkeit des Luftdrucks in der Prozesskammer (12) und/oder dem aktuellen Prozessschritt.

8. Nassprozessmodul nach einem der Ansprüche 5 bis 7, **dadurch gekennzeichnet, dass** der wenigstens eine Prozesstopfkanal (40) strömungsmäßig mit dem wenigstens einen Bypasskanal (42) verbunden ist, insbesondere stromabwärts der Regeleinrichtung (56) des Bypasskanals (42).

9. Nassprozessmodul nach einem der Ansprüche 5 bis 8, **dadurch gekennzeichnet, dass** der wenigstens eine Prozesstopfkanal (40) eine Lackfalle (50) und/oder keine Regeleinrichtung (56) aufweist.

10. Verfahren zum Betrieb eines Nassprozessmoduls (10) nach einem der vorhergehenden Ansprüche, mit den folgenden Schritten:
a) Zuführen eines bekannten, insbesondere eines konstanten, Volumenstroms an Luft durch den Lufteinlass (16) in die Prozesskammer (12), und
b) Steuern oder Regeln des Volumenstroms an Luft, der durch den wenigstens einen Bypassauslass (38) aus der Prozesskammer (12) austritt.

11. Verfahren nach Anspruch 10, **dadurch gekennzeichnet, dass** der Volumenstrom an Luft, der durch den wenigstens einen Bypassauslass (38) aus der Prozesskammer (12) austritt, durch eine Regeleinrichtung (56) in dem wenigstens einen Bypasskanal (42) gesteuert oder geregelt wird.

12. Verfahren nach Anspruch 10 oder 11, **dadurch gekennzeichnet, dass** der durchströmte Querschnitt des wenigstens einen Prozesstopfkanals (40) nicht aktiv verändert wird.

13. Verfahren nach einem der Ansprüche 10 bis 12, **dadurch gekennzeichnet, dass** der Luftdruck in der Prozesskammer (12) derart geregelt wird, dass in der Prozesskammer (12) ein Überdruck herrscht.

14. Verfahren nach einem der Ansprüche 10 bis 13, **dadurch gekennzeichnet, dass** über die Abluftvorrichtung (14) ein bekannter, insbesondere konstanter Volumenstrom an Luft aus der Prozesskammer (12) entnommen wird, insbesondere wobei der von der Abluftvorrichtung (14) entnommene Volumenstrom kleiner ist als der der Prozesskammer (12) zugeführte Volumenstrom an Luft.

## Revendications

1. Module de traitement par voie humide, en particulier module de laquage pour traiter des substrats, en particulier des wafers, comprenant une chambre de traitement (12) qui présente un pot de traitement (24) pour traiter le substrat, une entrée d'air (16) pour l'amenée d'air dans la chambre de traitement (12), au moins une sortie de dérivation (38), et au moins une sortie de pot de traitement (36),
ladite au moins une sortie de dérivation (38) et ladite au moins une sortie de pot de traitement (36) étant des sorties d'air pour l'évacuation d'air hors de la chambre de traitement (12), et
ladite au moins une sortie de pot de traitement (36) étant prévue dans le pot de traitement (24), et ladite au moins une sortie de dérivation (38) étant prévue à l'extérieur du pot de traitement (24).

2. Module de traitement par voie humide selon la revendication 1, **caractérisé en ce que** l'entrée d'air (16), d'une part, et les sorties d'air (36, 38), d'autre part, sont prévues de côtés différents, en particulier opposés, de la chambre de traitement (12), et/ou **en ce que** ladite au moins une sortie de pot de traitement (36) et ladite au moins une sortie de dérivation (38) sont prévues d'un même côté de la chambre de traitement (12).

3. Module de traitement par voie humide selon la revendication 1 ou 2, **caractérisé en ce que** ladite au moins une sortie de dérivation (38) s'étend au moins par tronçons selon une forme annulaire autour du pot de traitement (24), et/ou **en ce qu'**il est prévu une pluralité de sorties de dérivation (38) agencées autour du pot de traitement (24).

4. Module de traitement par voie humide selon l'une des revendications précédentes, **caractérisé en ce que** le module de traitement par voie humide (10) présente un capteur de pression (54) réalisé pour la détermination de la pression de l'air dans la chambre de traitement (12).

5. Module de traitement par voie humide selon l'une des revendications précédentes, **caractérisé en ce que** le module de traitement par voie humide (10) comprend un dispositif d'air évacué (14) présentant au moins un canal de pot de traitement (40) et au moins un canal de dérivation (42), ledit au moins un canal de pot de traitement (40) s'étendant depuis ladite au moins une sortie de pot de traitement (36), et ledit au moins un canal de dérivation (42) s'étendant depuis ladite au moins une sortie de dérivation (38).

6. Module de traitement par voie humide selon la revendication 5, **caractérisé en ce qu'**il est prévu un moyen de régulation (56), en particulier un clapet d'étranglement, dans ledit au moins un canal de dérivation (42), au moyen duquel la section du canal de dérivation (42) apte à être traversée par un flux peut être réglée.

7. Module de traitement par voie humide selon la revendication 6, **caractérisé en ce que** le module de traitement par voie humide (10) présente une unité de commande (52) qui est reliée au moyen de régulation (56) et/ou une unité d'alimentation (15) du module de traitement par voie humide, et qui est aménagée pour commander ou réguler le moyen de régulation (56) et/ou l'unité d'alimentation (15), en particulier en fonction de la pression de l'air dans la chambre de traitement (12) et/ou de l'étape de procédé actuelle.

8. Module de traitement par voie humide selon l'une des revendications 5 à 7, **caractérisé en ce que** ledit au moins un canal de pot de traitement (40) est relié de manière fluidique audit au moins un canal de dérivation (42), en particulier en aval du moyen de régulation (56) du canal de dérivation (42).

9. Module de traitement par voie humide selon l'une des revendications 5 à 8, **caractérisé en ce que** ledit au moins un canal de pot de traitement (40) présente un piège à laque (50) et/ou pas de moyen de régulation (56).

10. Procédé de mise en oeuvre d'un module de traitement par voie humide (10) selon l'une des revendications précédentes, comprenant les étapes suivantes :
a) l'amenée d'un débit volumique d'air connu, en particulier constant, dans la chambre de traitement (12) à travers l'entrée d'air (16), et
b) la commande en boucle fermée ou en boucle ouverte du débit volumique d'air sortant de la chambre de traitement (12) à travers ladite au moins une sortie de dérivation (38).

11. Procédé selon la revendication 10, **caractérisé en ce que** le débit volumique d'air sortant de la chambre de traitement (12) à travers ladite au moins une sortie de dérivation (38) est commandé en boucle fermée ou en boucle ouverte par un moyen de régulation (56) dans ledit au moins un canal de dérivation (42).

12. Procédé selon la revendication 10 ou 11, **caractérisé en ce que** la section dudit au moins un canal de pot de traitement (40) traversée par un flux n'est pas activement modifiée.

13. Procédé selon l'une des revendications 10 à 12, **caractérisé en ce que** la pression de l'air dans la chambre de traitement (12) est réglée de sorte qu'il règne une surpression dans la chambre de traitement (12).

14. Procédé selon l'une des revendications 10 à 13, **caractérisé en ce qu'**un débit volumique d'air connu, en particulier constant, est extrait de la chambre de traitement (12) via le dispositif d'air évacué (14), le débit volumique extrait par le dispositif d'air évacué (14) étant en particulier inférieur au débit volumique d'air amené dans la chambre de traitement (12).
